Europäisches Patentamt

European Patent Office

Office européen des brevets

(11) Publication number: **0 473 988 A1**

# EUROPEAN PATENT APPLICATION

(21) Application number: **91113633.1**

(22) Date of filing: **14.08.91**

(51) Int. Cl.5: **H01L 29/784**

(30) Priority: **29.08.90 US 574631**

(43) Date of publication of application:
**11.03.92 Bulletin 92/11**

(84) Designated Contracting States:
**DE FR GB**

(71) Applicant: **International Business Machines
Corporation
Old Orchard Road
Armonk, N.Y. 10504(US)**

(72) Inventor: **Jousse, Didier
25 Rue Pasteur
F-95320 Saint Leu-La Forêt(FR)**
Inventor: **Kanicki, Jerzy
P.O.B. 274
Katonah, NY 10536(US)**

(74) Representative: **Mönig, Anton, Dipl.-Ing. et al
IBM Deutschland GmbH Patentwesen und
Urheberrecht Schönaicher Strasse 220
W-7030 Böblingen(DE)**

(54) **Thin film transistor having amorphous/polycrystalline semiconductor channel region.**

(57) A thin film transistor device (10) formed upon a substrate (12) includes a source electrode (14) and a drain electrode (16) each electrically coupled to an active semiconductor channel region. The device also includes a gate electrode (30) electrically coupled to the active semiconductor channel region for controlling a magnitude of a current flow between the source electrode and the drain electrode. The active semiconductor channel region includes a first layer (24) and a second layer (26). The first layer is comprised of amorphous hydrogenated silicon (a-Si:H) and the second layer is comprised of poly-crystalline silicon. The second layer is interposed between the first layer and the gate electrode. The poly-crystalline silicon second layer can or cannot contain amorphous phase outside the grain boundaries. The poly-silicon layer of the active channel region provides a high value of field-effect mobility and ON-state current while the a-Si:H layer functions as a buffer layer and provides a low OFF-state current.

FIG.3

FIG.4

EP 0 473 988 A1

This invention relates generally to thin film semiconductor devices and, in particular, to thin film transistor (TFT) devices.

One application for TFT devices is addressing large area liquid crystal displays (LCDs). Ideally, such devices require a high ratio of ON to OFF currents, a suitable ratio having a value of $1:10^7$. An ideal TFT device should also exhibit a field-effect electron mobility within a range of $1cm^2V^{-1}s^{-1}$ to $10cm^2V^{-1}s^{-1}$. Presently known devices employ either poly-crystalline silicon (poly-silicon) or hydrogenated amorphous silicon (a-Si:H) as the active material of the TFT. However, each of these materials, when used alone, exhibits serious limitations.

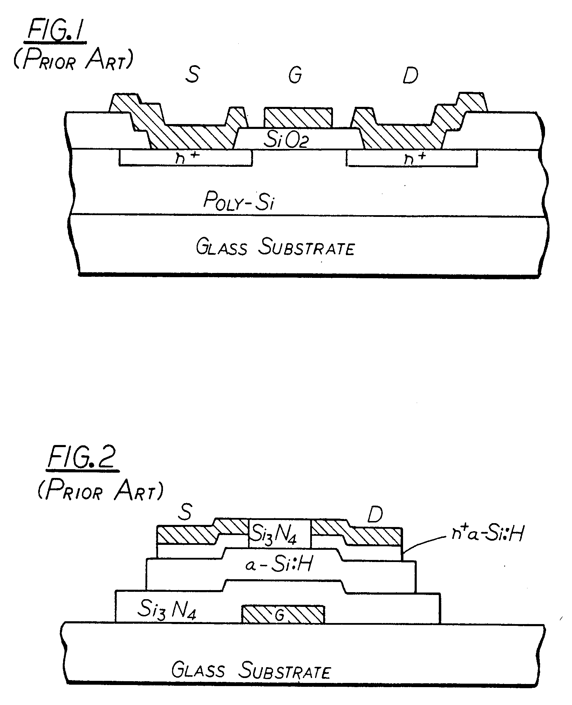

As can be seen in the prior art device of Fig. 1, a structure commonly used with poly-silicon material is a MOSFET-type structure. Although charge carrier mobilities between $10cm^2V^{-1}s^{-1}$ and $100cm^2V^{-1}s^{-1}$ have been achieved with this type of device, the OFF-state currents are unacceptably large. That is, these devices exhibit an ON/OFF current ratio of $1:10^5$ at best. One reason for the poor ON/OFF current ratio is the inferior quality of the junctions that occur with poly-silicon material. These inferior junctions are due primarily to a high density of grain boundary states which are believed to induce large currents across the reverse biased diode at the drain region, via the Poole-Frenkel conduction mechanism. As a result, device source and drain junctions, which are typically formed by ion implantation into deposited poly-silicon, are not sufficiently rectifying. Hence, the current for negative bias will be limited by either the formation of the positive charge sheet or Poole-Frenkel conduction.

Other prior art TFT devices are formed from a-Si:H. These devices are generally fabricated to have a different structure than the poly-silicon devices, the most common structure used being the inverted-staggered structure shown in Fig. 2. Relatively low values of OFF current are achieved due to the intrinsic high resistivity of a-Si:H and also because of an effective hole-blocking contact formed at the source and drain n+ a-Si:H/undoped a-Si:H junctions. However, the ON current of the device is established by an accumulation of electrons in the channel region and is intrinsically limited by the electron mobility of the amorphous material. At present, the best reported values of ON/OFF ratio and electron mobility for these devices are approximately $1:10^7$ and $1cm^2V^{-1}s^{-1}$, respectively. One significant limitation of a-Si:H devices is thus the relatively low electron mobility, as compared to poly-silicon material. Another significant limitation is an observed long term degradation of device operating performance under exposure to light or electrical operation. This degradation in device performance is presently explained as an increase in defect densities in the channel region, in a manner analogous to the Staebler-Wronski effect observed in solar cells.

In U.S. Patent 4,720,736, January 19, 1988, Takafuji et al. disclose a TFT device that includes an amorphous silicon film 43' as a conducting semiconductor layer. In U.S. Patent 4,727,044, February 23, 1988, Yamazaki discloses an insulated gate FET with a semiconductor layer formed of non-single-crystal semiconductor having crystallized regions 6S and 6D for forming effective source and drain regions. In commonly assigned U.S. Patent 4,741,964, May 3, 1988, I. Haller discloses a structure that includes a plurality of amorphous hydrogenated silicon layers differing from one another by the concentration of hydrogen.

In commonly assigned U.S. Patent 4,363,828, December 14, 1982 M. H. Brodsky and B. A. Scott disclose a method of producing hydrogenated amorphous Si films by the glow discharge of disilane or higher order silanes. Methods of depositing a hydrogenated silicon nitride film and a hydrogenated silicon dioxide film are also discussed.

It is an object of the invention to provide a new thin film semiconductor device exhibiting higher ON/OFF current ratios than known devices, with high electron mobility and improved stability.

The invention as claimed provides a structure having an amorphous hydrogenated silicon film layer adjacent to a micro-crystalline or a poly-crystalline silicon film layer.

In particular, the invention provides a TFT device having an active channel region formed by an amorphous hydrogenated silicon film layer disposed adjacent to a micro-crystalline or a poly-crystalline silicon film layer.

The invention further provides a TFT device and a method of fabricating same, the device having an active channel region comprised of an amorphous hydrogenated silicon film layer and an adjacent micro-crystalline or a poly-crystalline silicon film layer for providing both a large ON/OFF current ratio value and a large field-effect electron mobility value. A further aspect of this object of the invention is to provide an improvement in TFT stability and photosensitivity with this TFT structure.

The foregoing problems are overcome and the objects of the invention are realized by a thin film structure fabricated as set forth below. A thin film transistor device includes a source electrode and a drain electrode each electrically coupled to an active semiconductor channel region. The device further includes a gate electrode electrically coupled to the active semiconductor channel region for controlling a magnitude of a current flow through the active semiconductor channel region and between the source electrode and the drain electrode. In accordance with the invention the active semiconductor channel region includes a first layer and a second layer. The first layer is comprised of amorphous hydrogenated silicon and the second layer is comprised of micro-crystalline or poly-crystalline silicon. The second layer is interposed between the first layer and a gate dielectric.

As employed herein the difference between micro-crystalline silicon material and poly-crystalline silicon material is the content of the amorphous phase. In poly-crystalline silicon the content of the amorphous phase is negligible and is mainly located at the grain boundaries. In micro-crystalline silicon the content of the amorphous phase is variable.

In a first embodiment of the invention the source electrode and the drain electrode are each disposed upon a major surface of a substrate. The device further includes a first dielectric layer interposed between the first layer and the substrate, this first dielectric layer serving to planarize the device and to isolate the channel region from contaminates that may migrate upwards from the substrate. The device further includes a second dielectric layer interposed between the gate electrode and the second layer. This second dielectric layer is the aforementioned gate dielectric. The device further includes a first electrically conductive heavily doped (n+) amorphous or micro-crystalline hydrogenated silicon region for electrically coupling the source electrode to the first layer and a second electrically conductive heavily doped (n+) amorphous or micro-crystalline hydrogenated silicon region for electrically coupling the drain electrode to the first layer.

In a second embodiment of the invention the gate electrode is disposed upon a major surface of the substrate. The device further includes the gate dielectric layer interposed between the gate electrode and the second layer and the first and second electrically conductive heavily doped (n+) amorphous or micro-crystalline hydrogenated silicon regions for electrically coupling the source and drain electrodes to the first layer.

A presently preferred n+ dopant is phosphorous.

For both of these embodiments, and in accordance with the invention, the poly-crystalline or micro-crystalline silicon layer of the active channel region provides a high value of field-effect mobility and ON-state current typical of TFT devices having an active channel comprised only of poly-silicon material. Also, there is no degradation of these characteristics under illumination and voltage stress as is known to occur with a-Si:H material. Furthermore, the a-Si:H layer functions as a buffer layer and provides an OFF-state current equivalent to that typically associated with a TFT device having an active channel comprised only of a-Si:H material. The gate dielectric and passivation layer can be of a single-layer or a multi-layer composition. The source, drain and gate electrodes can also be of a single-layer or a multi-metal layer composition. The a-SiH layer is made sufficiently thin to avoid a significant voltage drop and light absorption if the TFT is not shielded from light.

The above set forth and other features of the invention are made more apparent in the ensuing detailed description of the invention when read in conjunction with the attached drawings, wherein:

Fig. 1    is a cross-sectional view, not to scale, of a TFT device of the prior art, the device having a poly-crystalline Si channel region;

Fig. 2    is a cross-sectional view, not to scale, of a TFT device of the prior art, the device having a hydrogenated amorphous Si channel region;

Fig. 3    is a cross-sectional view, not to scale, of one embodiment of a TFT device constructed in accordance with the invention as a top-gate non-inverted-staggered structure and having a bi-layer channel region comprised of a hydrogenated amorphous Si film layer that underlies an adjacent poly-crystalline Si or micro-crystalline Si film layer;

Fig. 4    is a cross-sectional view, not to scale, of a second embodiment of a TFT device constructed in accordance with the invention as a bottom-gate inverted-staggered structure and having a bi-layer channel region comprised of a hydrogenated amorphous Si film layer disposed above an adjacent poly-crystalline Si or micro-crystalline Si film layer; and

Fig. 5    is a flow diagram that depicts sequential steps of a method of the invention.

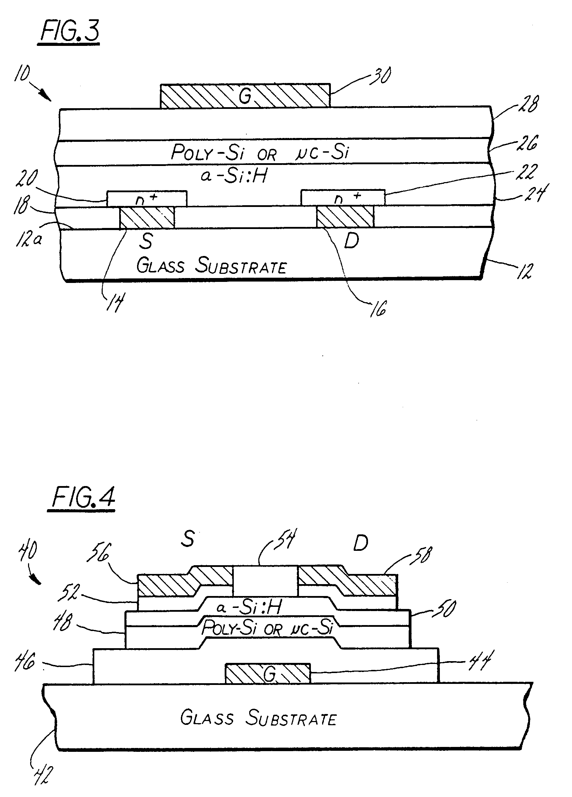

Referring first to Fig. 3 there is shown in cross-section and not to scale a first embodiment a TFT device 10 constructed in accordance with the invention. The TFT device 10 is fabricated upon a suitable passivated or non-passivated substrate 12, such as glass, and has a top-gate non-inverted-staggered structure that includes a source (S) electrode 14 and a drain (D) electrode 16 deposited directly upon an upper surface 12a of the substrate 12. Source and drain electrodes 14 and 16 may be comprised of Al, Mo, Cu, Cr or of any suitable electrically conductive material or alloy. The S and D can be deposited by evaporation, e-beam deposition, sputtering, or by a CVD technique. The source and drain electrodes (14,16) may be a single or a multi-metal layer structure. A first dielectric insulator layer 18 is comprised of a single layer of, by example, $SiN_x$:H, $SiO_x$:H or $SiN_xO_y$:H, or comprised of a bi-layer of, by example, $SiN_x$:H/$SiO_x$:H, or comprised of a tri-layer of, by example, $SiN_x$:H/$SiO_x$:H/$SiN_x$:H. Overlying the source electrode 14 is a first n+ contact layer 20 and overlying the drain electrode 16 is a second n+ contact layer 22. N+ contact layers 20 and 22 are comprised of a relatively thin layer of phosphorous-doped a-Si:H or micro-crystalline silicon. In accordance with the invention the source and drain electrodes 14 and 16 are electrically coupled by the n+ contact layers 20 and 22 to a bi-layer channel region that includes a hydrogenated amorphous Si (a-Si:H) film layer 24 that underlies and is adjacent to a poly-crystalline Si or micro-crystalline Si film layer 26. A gate insulator 28 of single-layer or multi-layer composition overlies the poly-silicon layer 26 and is comprised of, by example, $SiN_x$:H, $SiO_x$:H, $SiN_xO_y$:H $SiN_x$:H/$SiO_x$:H, or $SiN_x$:H/$SiO_x$:H/$SiN_x$:H. A gate (G) single-layer or multi-layer electrode 30 overlies the gate insulator layer 28. As used herein the active channel region is considered to be that portion of the layers 24 and 26 that underlies the gate electrode 30. During operation a voltage potential applied to the gate electrode 30 controls a magnitude of a current flow between the source and drain electrodes 14 and 16, the current flow occurring through the active channel region.

Representative dimensions of the TFT device 10 are as follows, it being realized that these dimensions may be varied over a large range. The device has a width and channel length of approximately 50 $\mu$m and 20 $\mu$m (50 microns and 20 microns), respectively. The source and drain electrodes 14 and 16 are each approximately 0.3 $\mu$m (microns) to approximately 0.5 $\mu$m (microns) thick and the gate electrode 30 has a thickness of approximately 0.3 $\mu$m (microns) to approximately 1 $\mu$m (micron). If the single gate dielectric layer is employed the constituent film layers have thicknesses as given below:

insulator layer 12a 0.3 to 0.5 $\mu$m (microns);
n+ layers 20 and 22 50 to 80 nm (500 to 800 Å);
a-Si:H layer 24 30 to 200 nm (300 to 2000 Å);
poly-silicon layer 26 20 to 150 nm (200 to 1500 Å); and
insulator layer 28 100 to 500 nm (1000 to 5000 Å).

The a-Si:H layer 24 should be sufficiently thin to avoid a significant voltage drop across the layer.

If a multi-layer gate dielectric layer 28 is employed instead the constituent film layers of layer 28 have thicknesses as given below:

for the bi-layer structure: 5 to 30 nm/100 to 500 nm (50 to 300Å/1000 to 5000Å); and
for the three-layer structure: 5 to 20 nm (50 to 200Å) (this layer is deposited first)/100 to 500 nm/5 to 20 nm (1000 to 5000Å/50 to 200Å).

In accordance with the invention the poly-silicon layer 26 of the active channel region provides a high value of field-effect mobility and ON-state current typical of TFT devices having an active channel comprised only of poly-silicon material. Also, there is no degradation of these characteristics under illumination and voltage stress as is known to occur with a-Si:H material. Furthermore, the a-Si:H layer 24 functions as a buffer layer and provides an OFF-state current equivalent to that typically associated with a TFT device having an active channel comprised only of a-Si:H material and controlled by the relatively higher quality of the n+/undoped a-Si:H contacts.

Also, the deposition of the dielectric layer 18 upon the glass substrate 12 has been found to aid in the planarization of the structure and to also prevent the contamination, during processing, of the device 10 from the glass substrate 12. This improves the quality of the source-gate line cross-over region, reduces the number of shorts at the cross-over locations, enhances yield, reduces a total number of required fabrication steps and improves device performance and stability.

Access to the drain/source contact interlayers 20 and 22 makes possible an in-situ or ex-situ cleaning step that is accomplished before deposition of the a-Si:H layer 24. This reduces contact resistance and thus serves to further improve device performance.

Direct access during processing to the channel region of the micro-crystalline or poly-crystalline semiconductor layer 26 is also made possible with this structure. Therefore, modification of the top gate dielectric 28/micro-crystalline or poly-crystalline semiconductor layer 26 interface is readily accomplished, which is not the case for a bottom gate TFT semiconductor interface. The modification of this interface by in-situ hydrogenation or nitridation techniques or by an ex-situ treatment serves to improve device performance. Furthermore, recrystalization of the channel layer is possible with or without the top gate dielectric layer 28. In this regard it has been found that the grain size of the poly-crystalline silicon layer 26 can be controlled through the use of the top gate dielectric layer 28. Specifically, the top gate dielectric layer 28 has been found to prevent the full crystallization of the a-Si:H layer. The combination of the thickness, silicon composition and crystallization time determines the grain size of the poly-silicon layer. This grain-size control is not available in the bottom-gate structure. The poly-crystalline silicon region may or may not contain an amorphous phase outside of the grain boundaries.

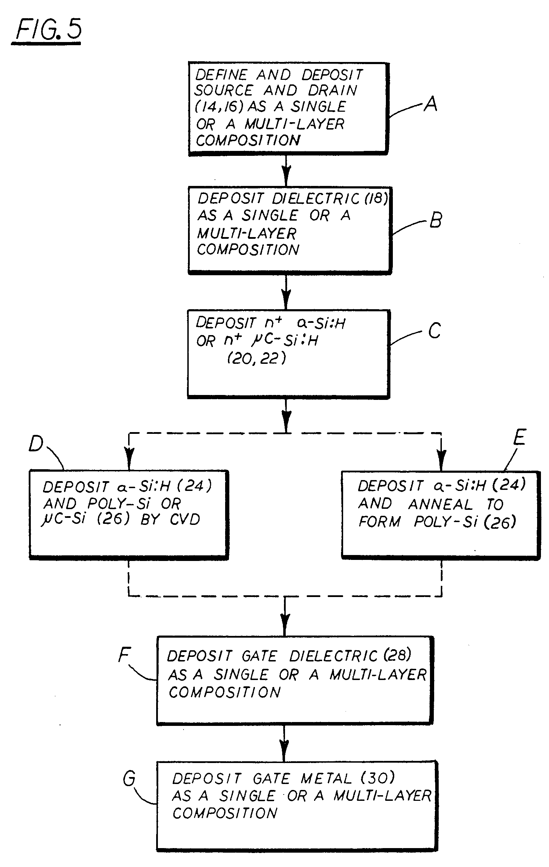

Referring now to Fig. 4 there is shown in cross-section, not to scale, a further embodiment of the invention, specifically a bottom-gate inverted-staggered TFT structure. A TFT device 40 is formed on a glass substrate 42 and includes a gate electrode 44. Overlying the gate electrode 44 is a layer of gate dielectric comprised of, for example, $SiN_x{:}H$ or $SiO_x{:}H$ if a single layer gate dielectric is used. However, the multi-layer dielectric structure described above is available for use. Overlying the dielectric single or multi-layer structure 46 is a micro-crystalline or a poly-crystalline silicon semiconductor layer 48. Overlying the layer 48 is an a-Si:H semiconductor layer 50. The active channel region is considered to be that portion of layers 48 and 50 that overlie the gate electrode 44. Overlying the a-Si:H layer 50 is a heavily phosphorous doped (n+) microcrystalline and/or an n+ a-Si:H contact layer 52. Overlying the contact layer 52 is a dielectric region 54 that electrically isolates a source electrode 56 from a drain electrode 58.

Material composition and layer thicknesses correspond to those of the similar structures of Fig. 3. All layers can be deposited by a single or multi-pump down process.

It is noted that in Figs. 3 and 4 the metal S (14, 56), D (16, 58) and G (30, 54) layer can be of a single-layer or a multi-layer composition. In addition, the gate dielectric (28, 46) and the gate metal G (20, 44) can also be of the single-layer or a multi-layer composition.

Fig. 5 is a flow diagram illustrating various sequentially performed steps of a method of the invention. The method of Fig. 5 refers specifically to the fabrication of the top-gate TFT device 10 depicted in Fig. 3, it being realized that a variation in the order that the steps are performed is required to produce the bottom-gate TFT device 40 of Fig. 4.

In Block A the drain 14 and source 16 contacts are defined on the glass substrate 12 by metal deposition by evaporation, e-beam, sputtering or any chemical vapor deposition techniques following patterning with photolithography. The drain 14 and source 16 contacts can be of the single or multi-layer composition. Metal alloys can also be used for contact fabrication.

In Block B the single or multi-layer dielectric 18 is deposited to achieve device planarization and to prevent subsequent channel contamination from the glass substrate 12. Vias are obtained by lithography for access to the metalization of the source 14 and drain 16 contacts.

In Block C n+ micro-crystalline or a-Si:H deposition following patterning by photolithography is accomplished to form the contact regions 20 and 22. The previously applied single or multi-layer dielectric 18 permits effective cleaning of the back-channel region. Phosphorus is a suitable n+ dopant.

The growth of the a-Si:H/micro-crystalline Si or poly-crystalline Si bi-layer may be accomplished by a variety of techniques. One preferred technique is indicated as Block D and involves the deposition during one deposition sequence of the a-Si:H layer 24 followed by micro-crystalline or poly-crystalline silicon to form the layer 26. This deposition sequence is readily accomplished by any chemical vapor deposition technique such as, for example, a Plasma-Enhanced-Chemical Vapor Deposition (PECVD) technique. The PECVD technique is preferably carried out at a relatively low temperature of approximately 300°C to 400°C. The changeover between amorphous and poly-crystalline or micro-crystalline Si is accomplished by increasing rf power density, substrate temperature and using hydrogen dilution for growth of the micro-crystalline Si. Other techniques such as: electron cyclotron resonance CVD (ECR-CVD), photo-enhanced CVD (Photo-CVD), high-vacuum CVD (HV-CVD), HV PECVD or low pressure CVD (LP-CVD) can also be used for deposition of this bi-layer structure.

It is noted that a grain size criteria is not used to distinguish between micro-crystalline and poly-crystalline Si. Instead, the amorphous-to-crystalline phase volume fraction is used to distinguish between micro-crystalline and poly-crystalline Si. In general, in poly-Si this volume fraction, i.e. the amorphous fraction, is negligible, which is not the case for micro-crystalline Si. Another suitable technique is illustrated as the Block E and deposits the entire channel region in the a-Si:H state by the PECVD, Photo-CVD, ECR-CVD, HV-CVD, HV-PECVD or LP-PCVD technique. The overlying poly-crystalline layer 26 is formed by a substantially uniform recrystallization of the upper surface region of the amorphous silicon layer with laser-assisted or flash-assisted rapid thermal annealing. By example, a source of annealing radiation may be an excimer laser or a high power incoherent source.

It is believed that this second technique (Block E) may result in a relatively large crystal grain size and, consequently, in very high electron mobilities. However, this second technique may be difficult to implement for very thin films (less than 100 nm) in that the underlying layer must retain device-grade a-Si:H properties despite the partial recrystallization.

In regard to the first technique (Block D) it has been shown that the grain size of the poly-crystalline or micro-crystalline Si layer 26 increases with film thickness and that the layer tends to be amorphous nearer to the substrate 12. This observation, coupled with the planarization achieved with the layer 18, makes the non-inverted structure of Fig. 3 a presently preferred embodiment. Also, Hall effect measurements done with this planar configuration show that effective electron mobilities of approximately $50cm^2V^{-1}s^{-1}$ and $10cm^2V^{-1}s^{-1}$ are achievable with poly-crystalline Si and with micro-crystalline Si, respectively, formed within the active channel region.

Block F shows gate single or multi-layer dielectric layer 28 deposition which may be accomplished by PECVD, ECR-CVD, Photo-CVD, HV-PECVD, HV-CVD or LPCVD technique in the same deposition sequence as Block D. In this regard it is noted that the a-Si:H layer 24, the micro-crystalline or poly-crystalline Si layer 26 and a gate dielectric layer 28 are all deposited in sequence with a single pump-down at a substrate temperature not exceeding 600°C. That is, the process is compatible with the use of common glass for the substrate 12. A multi pump-down technique can also be used to deposit the structure.

The gate dielectric layer 28 deposition may also be accomplished as a separate step if the flash anneal of Block E is accomplished. PECVD, HV-PECVD, Electron Cyclotron Resonance CVD, laser-assisted CVD, HV-CVD or LP-CVD deposition are all suitable techniques for deposition of a silicon nitride, silicon oxide, or a silicon oxynitride dielectric layer in single or multi-layer compositions.

A final step (Block G) involves deposition of single-layer or multi-layer gate metal following patterning by photolithography. The chemical composition of the gate metal can be that of a single metal or of an alloy.

One use for the TFT device of the invention is for addressing LCDs, wherein a large array of such devices are formed upon the substrate. Another use is in constructing driver circuits requiring high electron mobility and ON currents.

A traditional MOSFET technology (MOS or CMOS) can also be implemented for driver circuitry at a periphery of the LCD display without conflict with the processing methodology described above.

While the invention has been particularly shown and described with respect to a preferred embodiment thereof, it will be understood by those skilled in the art that changes in form and details may be made therein without departing from the scope and spirit of the invention.

**Claims**

1. A structure comprising:

    at least one first electrode means formed upon a major surface of a substrate;

    a bi-layer region overlying said at least one first electrode means; and

    at least one second electrode means overlying said bi-layer region, wherein said bi-layer region includes a first layer comprised of amorphous hydrogenated silicon and further includes a second layer comprised of micro-crystalline or poly-crystalline silicon, the first layer and the second layer being adjacent one to another.

2. A structure as set forth in Claim 1 and further comprising a first dielectric layer interposed between said bi-layer region and said substrate.

3. A structure as set forth in Claim 2 and further comprising a second dielectric layer interposed between said second electrode means and said bi-layer region.

4. A structure as set forth in Claim 1 wherein said at least one first electrode means is comprised either of a source electrode and a drain electrode or of a gate electrode, wherein the at least one second electrode means is comprised either of a gate electrode or of a source electrode and a drain electrode, and wherein the structure further comprises:

    a first electrically conductive micro-crystalline or amorphous hydrogenated silicon region for electrically coupling the source electrode to the first layer; and

    a second electrically conductive microcrystalline or amorphous hydrogenated silicon region for electrically coupling the drain electrode to the first layer.

5. A structure as set forth in Claim 3 wherein said first and said second dielectric layers are each comprised of a single layer or as a multi-layered structure.

6. A thin film transistor device comprising:

    a source electrode and a drain electrode each being electrically coupled to an active semiconductor channel region; and

    a gate electrode electrically coupled to the active semiconductor channel region for controlling a magnitude of a current flow through the active semiconductor channel region and between the source electrode and the drain electrode; wherein

the active semiconductor channel region includes a first layer and a second layer, the first layer being comprised of amorphous hydrogenated silicon and the second layer being comprised of micro-crystalline or of poly-crystalline silicon.

7. A thin film transistor device as set forth in Claim 6 wherein the second layer is interposed between the first layer and the gate electrode.

8. A thin film transistor device as set forth in Claim 7 wherein the source electrode and the drain electrode are each disposed upon a major surface of a substrate, and wherein the device further comprises:

a first single or multi-layer dielectric layer interposed between the first layer and the substrate;

a second single or multi-layer dielectric layer interposed between the gate electrode and the second layer;

a first electrically conductive n+ microcrystalline or amorphous hydrogenated silicon region for electrically coupling the source electrode to the first layer; and

a second electrically conductive n+ microcrystalline or amorphous hydrogenated silicon region for electrically coupling the drain electrode to the first layer.

9. A thin film transistor device as set forth in Claim 7 wherein the gate electrode is disposed upon a major surface of a substrate, and wherein the device further comprises:

a gate single or multi-layer dielectric layer interposed between the gate electrode and the second layer;

a first electrically conductive n+ microcrystalline or amorphous hydrogenated silicon region for electrically coupling the source electrode to the first layer; and

a second electrically conductive n+ microcrystalline or amorphous hydrogenated silicon region for electrically coupling the drain electrode to the first layer.

10. A thin film transistor device as set forth in Claim 6 wherein the electrodes may be comprised of a single metal or of an alloy.

11. A method of fabricating a thin film transistor device comprising the steps of:

providing a substrate;

forming at least one electrode upon the substrate;

forming an active channel region such that it overlies the at least one first electrode; and

forming at least one second electrode such that it overlies the active channel region; wherein

the step of forming the active channel region includes a step of forming a first layer comprised of amorphous hydrogenated silicon and includes a second step of forming a second layer adjacent to the first layer, the second layer being comprised of micro-crystalline silicon or of poly-crystalline silicon and both steps being preferably accomplished at a temperature that does not exceed approximately 600°C and preferably, being accomplished by a CVD technique.

12. A method as set forth in Claim 11 wherein the steps of forming the first layer comprised of amorphous hydrogenated silicon and forming the second layer adjacent to the first layer are accomplished by a step of depositing a layer of amorphous hydrogenated silicon followed by a step of recrystallizing and preferably a step of thermal or flash annealing a top surface region of the amorphous hydrogenated silicon layer.

13. A method as set forth in Claim 11 wherein the step of forming at least one electrode upon the substrate includes a step of depositing a single or multi-layer dielectric layer to substantially planarize the device prior to performing the step of forming the active channel region.

14. A method as set forth in Claim 11 wherein the step of forming at least one electrode upon the substrate includes a step of forming a source electrode and a drain electrode, and wherein the step of forming the active channel region includes the initial steps of forming a first electrically conductive n+ micro-crystalline or amorphous hydrogenated silicon region, preferably by doping the micro-crystalline or amorphous hydrogenated silicon with phosphorous, for electrically coupling to the source electrode and forming a second electrically conductive n+ micro-crystalline or amorphous hydrogenated silicon region, preferably by doping the micro-crystalline or amorphous hydrogenated silicon with phosphorous, for electrically coupling to the drain electrode.

FIG.1
(Prior Art)

FIG.2
(Prior Art)

## FIG.3

POLY-Si OR µC-Si

a-Si:H

n⁺

n⁺

S

D

GLASS SUBSTRATE

## FIG.4

S        D

a-Si:H

POLY-Si OR µC-Si

G

GLASS SUBSTRATE

## FIG. 5

DEFINE AND DEPOSIT
SOURCE AND DRAIN
(14,16) AS A SINGLE
OR A MULTI-LAYER
COMPOSITION — A

DEPOSIT DIELECTRIC (18)
AS A SINGLE OR A
MULTI-LAYER
COMPOSITION — B

DEPOSIT n⁺ a-Si:H
OR n⁺ μC-Si:H
(20,22) — C

D — DEPOSIT a-Si:H (24)
AND POLY-Si OR
μC-Si (26) BY CVD

DEPOSIT a-Si:H (24)
AND ANNEAL TO
FORM POLY-Si (26) — E

F — DEPOSIT GATE DIELECTRIC (28)
AS A SINGLE OR A MULTI-LAYER
COMPOSITION

G — DEPOSIT GATE METAL (30)
AS A SINGLE OR A MULTI-LAYER
COMPOSITION

European Patent
Office

EUROPEAN SEARCH REPORT

Application Number

EP    91 11 3633
Page 1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN<br>vol. 9, no. 263 (E-351)(1986) 19 October 1985<br>& JP-A-60 109 284 ( SUWA SEIKOSHA K.K. ) 14 June 1985<br>* abstract *<br>--- | 1,3-7,<br>11,12 | H01L29/784 |
| X | PATENT ABSTRACTS OF JAPAN<br>vol. 012, no. 265 (E-637)23 July 1988<br>& JP-A-63 047 980 ( FUJITSU LTD ) 29 February 1988 | 1,3,5,6,<br>7,10-12 | |
| A | * abstract *<br>--- | 8 | |
| E | EP-A-0 449 539 (KABUSHIKI KAISHA TOSHIBA)<br><br>* column 4, line 47 - column 5, line 20; figures *<br>--- | 1,2,4-6,<br>9-11,14 | |
| A | PATENT ABSTRACTS OF JAPAN<br>vol. 009, no. 248 (E-347)4 October 1985<br>& JP-A-60 098 680 ( SEIKO DENSHI KOGYO KK ) 1 June 1985 | 1,2,4-6 | |
| A | * abstract *<br>--- | 9 | **TECHNICAL FIELDS SEARCHED (Int. Cl.5)**<br><br>H01L |
| A | PATENT ABSTRACTS OF JAPAN<br>vol. 014, no. 489 (E-0994)24 October 1990<br>& JP-A-02 201 966 ( SUMITOMO METAL IND LTD ) 10 August 1990<br>* abstract *<br>--- | 1,2,4-6,<br>9 | |
| A | PATENT ABSTRACTS OF JAPAN<br>vol. 012, no. 246 (E-632)12 July 1988<br>& JP-A-63 036 574 ( HITACHI LTD ) 17 February 1988<br>* abstract *<br>--- | 1,4,9,13 | |

-/--

The present search report has been drawn up for all claims

| Place of search | Date of completion of the search | Examiner |
|---|---|---|
| THE HAGUE | 23 DECEMBER 1991 | B.J. MIMOUN |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | PATENT ABSTRACTS OF JAPAN vol. 014, no. 214 (P-1044)7 May 1990 & JP-A-02 047 633 ( SHARP CORP ) 16 February 1990 * abstract * | 1,4,9,13 | |
| A | PATENT ABSTRACTS OF JAPAN vol. 011, no. 004 (E-468)7 January  1987 & JP-A-61 181 164 ( MATSUSHITA ELECTRIC IND CO LTD ) 13 August 1986 * abstract * | 2,13 | |
| A | PATENT ABSTRACTS OF JAPAN vol. 010, no. 255 (E-433)2 September 1986 & JP-A-61 084 066 ( OKI ELECTRIC IND CO LTD ) 28 April 1986 * abstract * | 2,13 | |
| A | INTERNATIOAL ELECTRON DEVICES MEETING 1989. TECHNICAL DIGEST. CONFERENCE: WASHINTON, DC, USA, 3-6 DEC 1989 pages 157 - 160; HIROYUKI OHSHIMA ET AL: 'FUTURE TRENDS FOR TFT INTEGRATED CIRCUITS ON GLASS SUBSTRATES' * abstract; figure 1 * | 11 | TECHNICAL FIELDS SEARCHED (Int. Cl.5 ) |

The present search report has been drawn up for all claims

| Place of search | Date of completion of the search | Examiner |
|---|---|---|
| THE HAGUE | 23 DECEMBER 1991 | B.J. MIMOUN |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P0401)